# EUROPEAN PATENT APPLICATION

(11) **EP 4 564 678 A1**
(43) Date of publication of application: **04.06.2025**
(21) Application number: 23213663.0
(22) Date of filing: 01.12.2023
(51) Int. Cl.: H03K 17/18, H03K 17/785, H03K 17/605, H03K 17/082, H03K 17/689

(54) **PROGRAMMABLE GATE DRIVER CIRCUIT FOR AN INTEGRATED POWER SWITCH**

(71) Applicant: Infineon Technologies Austria AG, 9500 Villach (AT)
(72) Inventor: BERNARDON, Derek, 9524 Villach (AT); FERIANZ, Thomas, 9551 Bodensdorf (AT); SEEBACHER, Markus, 9241 Wernberg (AT)
(74) Representative: Infineon Patent Department

(57) **Abstract**

A gate driver circuit and a corresponding gate driver system is presented. The gate driver circuit may be configured to drive a gallium nitride GaN transistor. The gate driver circuit may comprise a communication interface configured to receive a gate driver parameter. The communication interface may be an asynchronous serial communication interface, such as e.g. an UART communication interface. The gate driver parameter may be forwarded from one gate driver circuit to the next using the asynchronous serial communication protocol. One or more digital isolators may be coupled between the gate driver circuits.

## Description

### Technical field

The present document relates to gate driver circuits for an integrated power switch. In particular, the present document relates to programming one or more gate driver circuits, wherein each gate driver circuit is configured to drive a Gan transistor.

### Background

GaN transistors have a high breakdown tolerance, faster-switching speeds, enhanced thermal conductivity, and lower on-resistance comparted to their MOSFET counterparts. However, as with most power transistors, the key to getting all the benefits out of GaN transistor is proper gate control. The physical properties of the GaN transistor and the implemented gate concept have a strong impact on the optimum driving scheme. Thus, it is desirable to have a reliable mechanism of programming and re-programming (i.e. on the fly or during operation) the gate driver circuit used to drive a GaN transistor. Moreover, it is desirable to have a reliable mechanism to program a plurality of gate driver circuits in an efficient manner. Furthermore, it is an object of the present invention to reliable program gate driver circuits even in the presence of electromagnetic noise, CMTI, and other disturbances.

### Summary

According to an aspect, a gate driver circuit is presented. The gate driver circuit may be configured to drive a gallium nitride GaN transistor. The gate driver circuit may comprise a communication interface configured to receive a gate driver parameter. The communication interface may be an asynchronous serial communication interface.

The GaN transistor may be implemented using a III-V compound semiconductor material. For instance, the GaN transistor may be e.g. a GaN- high-electron-mobility transistor HEMT. The GaN transistor may be operated as a switching element. The GaN transistor may have one or more gates to which respective driving signals (such as driving voltages/currents) may be applied to turn the GaN transistor on (i.e. to close the switching element) or to turn the GaN transistor off (i.e. to open the switching element). The GaN transistor may be a GaN bidirectional switch BDS. In other words, the GaN transistor may be configured to block currents in both directions when turned off. The GaN transistor may have two gates, two sources and a common drain. Without loss of generality, one gate of the GaN transistor may be denoted as positive gate with regard to a source, and the other gate of the GaN transistor may be denoted as negative gate with regard to a source.

The gate driver circuit may be an isolated gate driver circuit. The gate driver circuit may be configured to generate driving voltages/currents for driving the gates (e.g. the positive and the negative gate) of the GaN transistor. In particular, the gate driver circuit may be configured to generate the driving voltages/currents based on the received gate driver parameter.

Compared to synchronous serial communication interfaces, such as e.g. inter-integrated circuit I2C communication interfaces, the asynchronous serial communication interface does not require continuous synchronization e.g. by a common clock signal.

The communication interface may be configured to forward the received gate driver parameter to another gate driver circuit or to an external control circuit.

Forwarding the received gate driver parameter may have several advantages. On the one hand, by forwarding the received gate driver parameter to another gate driver circuit, it becomes possible to daisy-chain gate driver circuits. In this way, the number of pins of the external control circuit may be reduced compared to a scenario in which the external control circuit is electrically connected to each gate driver circuit and separately transmits the gate driver parameter to each gate driver circuit. On the other hand, forwarding the received gate driver parameter to the external control circuit may enable the external control circuit to verify whether the gate driver parameter was correctly transmitted to one or more gate driver circuits by comparing the gate driver parameter received from the last of the one or more gate driver circuits with the gate driver parameter which was originally sent by the external control circuit to a first of the one or more gate driver circuits. Alternatively or additionally, safety of the data communication may be increased using parity bits and/or cyclic redundancy checks CRCs.

The external control circuit may be a microcontroller unit (MCU). For example, the MCU may be implemented on a single integrated circuit. The MCU may contain one or more CPUs (processor cores) along with memory and programmable input/output peripherals. As will be discussed in the following description, the external control unit may comprise a similar or identical communication interfaces as the gate driver circuit (e.g. an asynchronous serial communication interface) for enabling communication between the gate driver circuit.

The gate driver parameter may be a gate current parameter, and the gate driver circuit may be configured to generate a gate current for driving the GaN transistor based on the gate current parameter.

For example, the gate current parameter may be indicative of a reduced hold current value. The gate driver circuit may be configured to reduce the gate current from an initial current value to said reduced hold current value. For example, the gate current may be a gate current applied to the positive gate of the GaN transistor. Moreover, the gate driver circuit may be configured to not reduce the initial current value during an initial time interval (e.g. a 50Hz half period, or 0,01s) after the GaN transistor has been turned on. Subsequently, the gate driver circuit may be configured to, after the initial time interval has lapsed, reduce the initial current value to the reduced hold current value. In this way, damages at the negative gate (which may be in off condition) due to hole injection at the positive gate may be reduced/avoided and the reliability of the GaN transistor may be increased. The gate current parameter may also be indicative of a duration of said initial time interval.

The gate driver parameter may be a gate voltage parameter, and the gate driver circuit may be configured to generate a gate voltage for driving the GaN transistor based on the gate voltage parameter. For example, the gate voltage parameter may be indicative of a voltage gradient dv/dt, and the gate driver circuit may be configured to generate the gate voltage according to said voltage gradient dv/dt.

The gate driver circuit may be configured to determine a temperature value of the GaN transistor, and the communication interface may be configured to transmit said temperature value to an external control circuit or to another gate driver circuit.

For example, the temperature value may be a digital temperature value. The gate driver circuit may comprise a temperature sensing unit configured to determine the temperature value. Alternatively, the temperature sensing unit may be partly implemented on the gate driver circuit, and partly on the GaN transistor. The temperature value may be directly transmitted to the external control circuit, or may be successively forwarded from gate driver circuit to gate driver circuit until it reaches the external control circuit.

The gate driver circuit may be configured to determine a current value indicative of a current flowing through the GaN transistor, and the communication interface may be configured to transmit said current value to an external control circuit or to another gate driver circuit.

The current flowing through the GaN transistor may be e.g. a drain-source current of the GaN transistor. The gate driver circuit may comprise a current sensing unit for sensing the current through the GaN transistor. Alternatively, the current sensing unit may be partly implemented on the gate driver circuit, and partly on the GaN transistor. The current value may be directly transmitted to the external control circuit, or may be successively forwarded from gate driver circuit to gate driver circuit until it reaches the external control circuit. The current value may be a digital current value.

The external control circuit may then be configured to receive said current value, determine an updated gate driver parameter based on the current value received from the gate driver circuit, and transmit the updated gate driver parameter back to the gate driver circuit for minimizing power consumption of the gate driver circuit.

The gate driver circuit may be configured to determine a fault condition related to the GaN transistor or to the gate driver circuit, and the communication interface may be configured to transmit a signal indicative of the fault condition to an external control circuit or to another gate driver circuit.

The fault condition may be e.g. triggered by a temperature exceeding an temperature threshold (over temperature protection OTP), by a voltage exceeding a voltage threshold (over voltage protection OVP), or by a current exceeding a current threshold (over current protection OCP). In particular, the fault condition may be triggered when saturation of the GaN transistor is detected (saturation detection) or when a short-circuit is detected (short circuit protection SCP). Both saturation and short-circuits may be detected based on the drain-source currents and/or voltage of the GaN transistor (e.g. by sensing and comparison with suitable threshold values). For example, the received gate driver parameter may be indicative of the saturation current threshold, or the gate driver circuit may be configured to determine the saturation current threshold based on the received gate driver parameter.

The communication interface may be a universal asynchronous receiver-transmitter UART interface.

According to another aspect, an integrated power switch is presented. The integrated power switch may comprise a GaN transistor, and a gate driver circuit as described in the foregoing description. The gate driver circuit may be coupled to a gate of the GaN transistor.

According to yet another aspect, a gate driver system is presented. The gate driver system may comprise a first gate driver circuit as described in the foregoing description. The gate driver system may comprise a first digital isolator circuit configured to receive the gate driver parameter and to transmit the gate driver parameter to the first gate driver circuit.

The first digital isolator circuit may be configured to ensure isolated signal forwarding to the first gate driver. In general, using a digital isolator circuit may be beneficial for communicating signals between systems with different ground potentials. With the help of galvanic isolation, the first digital isolator may enable communication without conducting ground loops or hazardous voltages.

For example, the first digital isolator circuit may be configured to receive said gate driver parameter from a control circuit. The first digital isolator circuit may be configured to receive and transmit the gate driver parameter using an asynchronous serial communication protocol, and in particular using the UART communication protocol.

The first digital isolator circuit and the first gate driver circuit may be both coupled to the same reference potential. Throughout this document, the term "reference potential" is meant in its broadest possible sense. In particular, the reference potential is not limited to ground i.e. a reference potential with a direct physical connection to earth or a voltage of 0V. Rather, the term "reference potential" may refer to any reference point to which and from which electrical currents may flow or from which voltages may be measured. Moreover, it should be mentioned that the reference potentials mentioned in this document may not necessarily refer to the same physical contact. Instead, the reference potentials mentioned in this document may relate to different physical contacts although reference is made to "the" reference potential for ease of presentation.

The first digital isolator circuit may comprise a push-pull output stage. The push-pull output stage may drive with very low impedance a digital input pad of the gate driver circuit, which makes said digital input pad much less susceptible to noise injection due to conducted or radiated electromagnetic interference EMI injection or Common Mode Transient Immunity CMTI.

The first digital isolator circuit may be a two-channel digital isolator circuit. An output pin of the first digital isolator associated with a first channel may be coupled to the communication interface of the gate driver circuit. An input pin of the first digital isolator circuit associated with a second channel may be coupled to the communication interface of the gate driver circuit. The first digital isolator circuit may be configured to transmit the gate driver parameter from the output pin to the communication interface of the gate driver circuit. The gate driver circuit may be configured to forward the gate driver parameter via the input pin of the first digital isolator circuit (and may be via another digital isolator circuit) to another gate driver circuit. In general, the digital isolator circuit may comprise an arbitrary number of channels. For instance, the digital isolator circuit may also have three channels, wherein the third channel may be used for transmitting a pulse width modulation PWM signal for driving the GaN transistor. The gate driver circuit may also forward other feedback information (such as e.g. sensed current values, sensed temperature values, or fault conditions) via the input pin of the first digital isolator circuit (and may be via another digital isolator circuit) to another gate driver circuit.

The gate driver system may comprise a second gate driver circuit. The first gate driver circuit may be configured to transmit the gate driver parameter via the first digital isolator circuit to the second gate driver circuit. The gate driver system may also comprise a second digital isolator circuit, and the first gate driver circuit may be configured to transmit the gate driver parameter via the first digital isolator circuit and via the second digital isolator circuit to the second gate driver circuit. This may be in particular advantageous in a gate driver systems in which each gate driver circuit has its own digital isolator circuit, and all digital isolator circuits are implemented as two-channel digital isolator circuits, wherein one channel is used to transmit the gate driver parameter to the gate driver circuit, and wherein the other channel is used to receive the gate driver parameter or other feedback information (such as e.g. sensed current values, sensed temperature values, or fault conditions) from the gate driver circuit.

Again, the second digital isolator circuit and the second gate driver circuit may be coupled to the same reference potential. Again, by daisy-chaining, the gate driver parameter may be successively forwarded from gate driver circuit to gate driver circuit, thereby saving communication pins at the external control circuit (which is controlling/programming all gate driver circuits).

The gate driver system may comprise a control circuit configured to transmit the gate driver parameter to the first digital isolator. The control circuit may be a microcontroller unit (MCU). For example, the MCU may be implemented on a single integrated circuit. The MCU may contain one or more CPUs (processor cores) along with memory and programmable input/output peripherals. The control circuit may be configured to receive the gate driver parameter from the a third digital isolator circuit, the third digital isolator circuit forwarding the gate driver parameter from the second gate driver circuit to the control circuit. As already mentioned in the foregoing description, the control circuit may be configured to compare the received gate driver parameter with the one originally transmitted (via the first digital isolator circuit) to the first gate driver circuit.

The communication between all entities, i.e. between the control circuit, the gate driver circuits and the digital isolator circuits may be based on an asynchronous serial communication protocol, and in particular on the UART communication protocol.

According to yet another aspect, a method of programming one or more gate driver circuits is presented. The method may comprise steps corresponding to the functional features of the gate driver system described throughout this document. Specifically, the method may comprise transmitting, by a first digital isolator, using an asynchronous serial communication protocol, a gate driver parameter to a first gate driver circuit. For example, the communication protocol may be the UART communication protocol. The first digital isolator circuit and the first gate driver circuit may be both coupled to the same reference potential. The first digital isolator circuit may comprise a push-pull output stage.

The method may comprise transmitting, by the first gate driver circuit, using the asynchronous serial communication protocol, the gate driver parameter via the first digital isolator circuit to a second gate driver circuit. In particular, the method may comprise transmitting the gate driver parameter via the first digital isolator circuit and via a second digital isolator circuit to the second gate driver circuit. Transmission via at least 2 digital isolator circuits may be recommendable if multi-channel isolators are used which are not capable of isolating the different channels from each other. Last but not least, the method may comprise transmitting, by a control circuit, the gate driver parameter to the first digital isolator.

It should be noted that the methods and systems including its preferred embodiments as outlined in the present document may be used stand-alone or in combination with the other methods and systems disclosed in this document. In addition, the features outlined in the context of a system are also applicable to a corresponding method. Furthermore, all aspects of the methods and systems outlined in the present document may be arbitrarily combined. In particular, the features of the claims may be combined with one another in an arbitrary manner.

In the present document, the term "couple" or "coupled" refers to elements being in electrical communication with each other, whether directly connected e.g., via wires, or indirectly connected via other circuit elements between them. For example, two elements may be said to be coupled even if there is a circuit element such as a switch (which may be turned on and off) in between them. On the other hand, the term "connect" or "connected" refers to elements being directly electrically connected with each other, e.g. via wires, and no circuit elements are located between them.

### Short description of the figures

The present invention is illustrated by way of example, and not by way of limitation, in the figures in which like reference numerals refer to similar or identical elements, and in which
Fig. 1 shows an exemplary gate driver system comprising four daisy-chained gate driver circuits and a control circuit,
Fig. 2 shows an exemplary gate driver system comprising two gate driver circuits which are directly programmable by a control circuit, and
Fig. 3 shows an exemplary gate driver system comprising four parallel gate driver circuits and a control circuit.

### Detailed Description

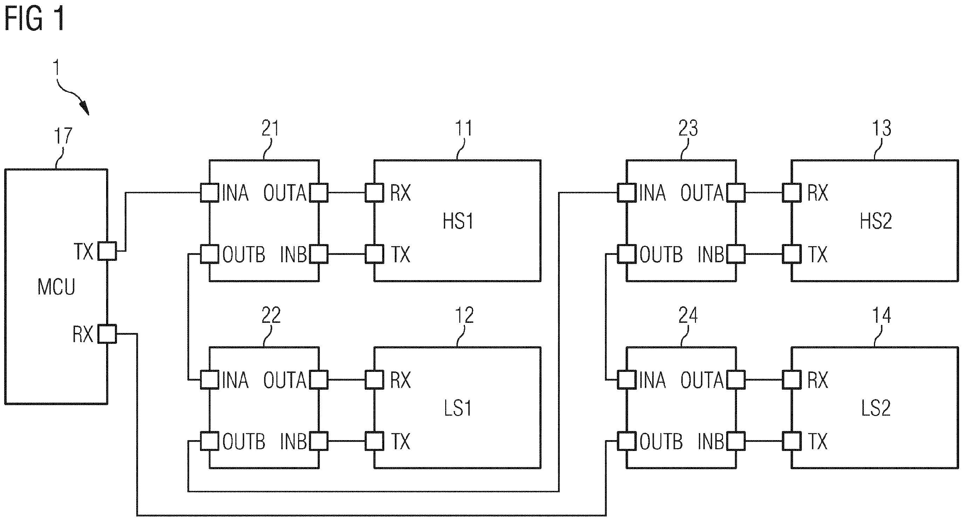

Fig. 1 shows an exemplary gate driver system 1 comprising four daisy-chained gate driver circuits 11, 12, 13, 14 and a control circuit 17. In addition, four digital isolators 20, 21, 22, 23 are depicted. Each gate driver circuit comprise a communication interface with a receive (RX) and a transmit (TX) portion. For example, the communication interfaces may be configured to establish communication based on the UART protocol.

All depicted digital isolators in the example are 2-channel digital isolators: A first channel is responsible for forwarding a signal (including e.g. a gate driver parameter) from input pin INA to output pin OUT A. A second channel is responsible for forwarding a signal (including e.g. the gate driver parameter) from input pin INB to output pin OUTB. In this way, a signal may be propagated from the control circuit 17 to all gate driver circuits for programming them. In this example, the gate driver system is configured to driver two half bridges, wherein the first half-bridge comprises a high-side GaN transistor driven by gate driver circuit 11 and a low-side GaN transistor driver by gate driver circuit 12. The second half-bridge comprises a high-side GaN transistor driven by gate driver circuit 13 and a low-side GaN transistor driver by gate driver circuit 14. The presented gate driver system 1 may be extended to drive an arbitrary number of half-bridges.

In this way, the gate driver parameter may be forwarded to all gate driver circuits and may be finally sent back to the control circuit 17 for a consistency check.

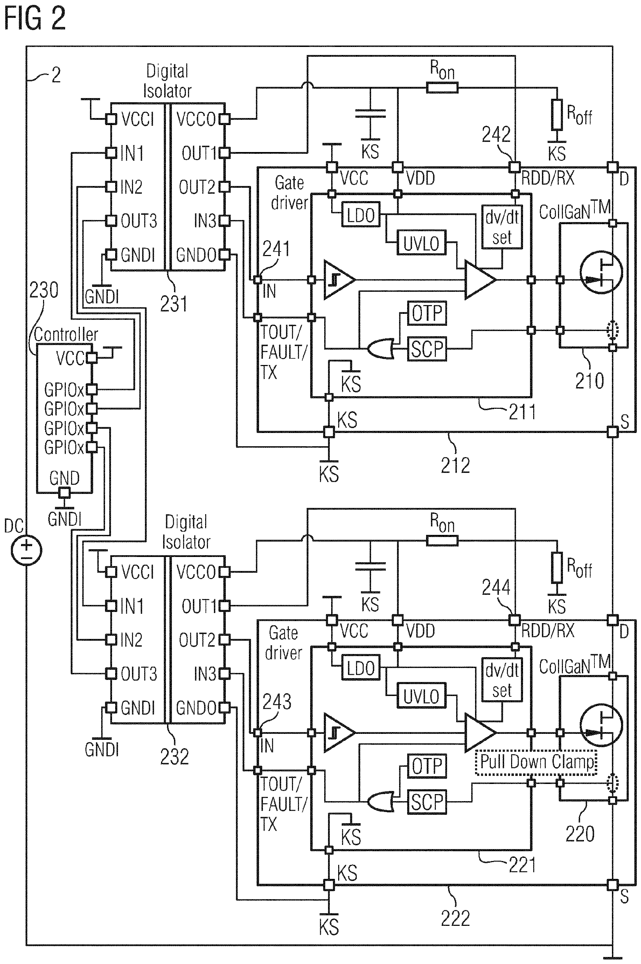

Fig. 2 shows a power stage 2 including an exemplary gate driver system comprising two integrated gate driver circuits 211, 221 and a control circuit 230. The two integrated gate driver circuits 211, 22 are directly programmable by the control circuit 232 via digital isolators 231, 232. Hence, in contrast to the daisy-chain configuration of Fig. 1, the gate driver circuits 211, 221 are controlled in parallel.

The gate driver circuit 211 is integrated together with GaN transistor 210 in an integrated power switch 212. The gate driver circuit 211 senses a drain-source current of GaN transistor 210, performs, for example, saturation detection, short circuit protection SCP as well as over temperature protection OTP. The gate driver circuit 211 receives via pin 241 a gate current parameter (as first gate driver parameter) from the control circuit 230. Similarly, the gate driver circuit 211 receives via pin 242 a gate voltage parameter (as second gate driver parameter) from the control circuit 230. The gate driver circuit 21 1 drives the GaN transistor 210 based on the two received parameters. Pins 241 and 242 form part of a communication interface, which may be e.g. a UART communication interface.

Similarly, the gate driver circuit 221 is integrated together with GaN transistor 22 in an integrated power switch 222. The gate driver circuit 221 receives via pin 243 a gate current parameter via digital isolator 232, and receives via pin 244 a gate voltage parameter via digital isolator 232. Both gate driver circuits 211 and 221 may be similar or identical, and redundant description is omitted here.

Thus, the example circuit in Fig. 2 depicts a scenario in which 3 channels of the digital isolators are used: A first channel is used to transmit the gate voltage parameter to the gate driver circuit. A second channel is used to transmit the gate current parameter to the gate driver circuit. A third channel is used to transmit feedback information such as e.g. sensed current values, sensed temperature values, or fault conditions from the driver circuit back to the control circuit 230.

From Fig. 1, it becomes evident that using a UART protocol and daisy-chaining gate drivers circuits may reduce the number of pins used by the control circuit. The communication may be established via digital isolators. As a result, the benefits of using the concepts presented within this disclosure are several. Firstly, the digital isolators and the drivers may share the same ground, which may be e.g. kelvin ground. Thus, the digital signal coming for the digital isolator and the digital input pad (RX) may not see significant ground shifting. Secondly, the digital isolator may provide a push-pull output stage which can drive with very low impedance the digital input pad (RX), which may make it much less susceptible to noise injection due to conducted or radiated EMI injection or CMTI. Thirdly, with daisy-chaining, the number of pins required from the controller for programming and communication may be reduced to only 2, independently of the number of devices used. And fourthly, the safety of the data communication may be done by a parity bit and or CRC, and by reading back the data into the controller to verify that it is the same as that what was sent. All these features make on the fly communication and programming much safer, and the data may be verified each time it is transferred from device to device in a daisychain topology.

The impact this has on the system may be significant. With a minimum of two additional pins required by the controller, the system may now program on the fly e.g. the dv/dt and the hold current, and saturation current levels. This may be important for reliability, power consumption and startup of certain topologies. It may also be possible to read out which fault is triggered in case of a fault and it may be read out the temperature in a digital form. This may give significant benefits as the amount of power being used may be controlled, and thus power consumption may be reduced when the load isn't significant. Also, they can increase the saturation current by increasing the hold current when they know the load is about to increase. This may increase the reliability of a gate injection transistor GIT GaN device as it is not always driven with maximum gate current and ensures that the saturation doesn't occur under normal operating conditions. This is a feature that is only feasible with a GIT device which with this programmability gives it an advantage over the other types of transistors which only use Schottky gate devices, which saturation level cannot be controlled.

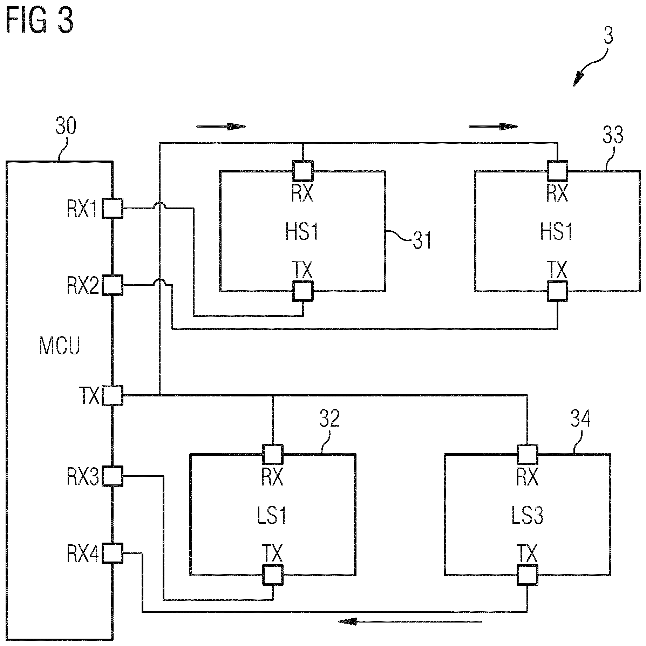

Fig. 3 shows an exemplary gate driver system 3 comprising four parallel-chained gate driver circuits 31, 32, 33, 34 and a control circuit 30. Please note that, without loss of generality, digital isolator circuits between the gate driver circuits are not illustrated in Fig. 3 for clarity of presentation. However, there may be a need to have at least one digital isolator circuit per each gate driver circuit illustrated in Fig. 3. The term "parallel-chained" describes the fact that all gate drivers are programmed in parallel and may receive the same gate driver parameters from controller 30. The gate drivers then report their feedback information individually back to controller 30. This parallel-chained driver topology may result in a larger number of required pins at the controller 30 and a shorter programming time (compared to the previously discussed daisy-chained driver topology).

It should be noted that the description and drawings merely illustrate the principles of the proposed methods and systems. Those skilled in the art will be able to implement various arrangements that, although not explicitly described or shown herein, embody the principles of the invention and are included within its spirit and scope. Furthermore, all examples and embodiment outlined in the present document are principally intended expressly to be only for explanatory purposes to help the reader in understanding the principles of the proposed methods and systems. Furthermore, all statements herein providing principles, aspects, and embodiments of the invention, as well as specific examples thereof, are intended to encompass equivalents thereof.

## Claims

1. A gate driver circuit configured to drive a gallium nitride GaN transistor, the gate driver circuit comprising a communication interface configured to receive a gate driver parameter, wherein the communication interface is an asynchronous serial communication interface.

2. The gate driver circuit according to claim 1, wherein the communication interface is configured to forward the received gate driver parameter to another gate driver circuit or to an external control circuit.

3. The gate driver circuit according to claim 1 or 2, wherein the gate driver parameter is a gate current parameter, and wherein the gate driver circuit is configured to generate a gate current for driving the GaN transistor based on the gate current parameter.

4. The gate driver circuit according to any one of the preceding claims, wherein the gate driver parameter is a gate voltage parameter, and wherein the gate driver circuit is configured to generate a gate voltage for driving the GaN transistor based on the gate voltage parameter.

5. The gate driver circuit according to any one of the preceding claims, wherein the gate driver circuit is configured to determine a temperature value of the GaN transistor, and wherein the communication interface is configured to transmit said temperature value to an external control circuit or to another gate driver circuit.

6. The gate driver circuit according to any one of the preceding claims, wherein the gate driver circuit is configured to determine a current value indicative of a current flowing through the GaN transistor, and the communication interface is configured to transmit said current value to an external control circuit or to another gate driver circuit.

7. The gate driver circuit according to any one of the preceding claims, wherein the gate driver circuit is configured to determine a fault condition related to the GaN transistor or to the gate driver circuit, and wherein the communication interface is configured to transmit a signal indicative of the fault condition to an external control circuit or to another gate driver circuit.

8. The gate driver circuit according to any one of the preceding claims, wherein the communication interface is a universal asynchronous receiver-transmitter UART interface.

9. An integrated power switch comprising
- a GaN transistor, and
- a gate driver circuit according to any one of the preceding claims, wherein said gate driver circuit is coupled to a gate of the GaN transistor.

10. A gate driver system comprising
- a first gate driver circuit according to any one of claims 1 to 8, and
- a first digital isolator circuit configured to receive the gate driver parameter and to transmit the gate driver parameter to the first gate driver circuit.

11. The gate driver system according to claim 10, wherein the first digital isolator circuit and the first gate driver circuit are both coupled to the same reference potential.

12. The gate driver system according to claim 10 or 11, wherein the first digital isolator circuit comprises a push-pull output stage.

13. The gate driver system according to any one of claims 10 to 12, wherein the first digital isolator circuit is a two-channel digital isolator circuit, and an output pin of the first digital isolator associated with a first channel is coupled to the communication interface of the gate driver circuit, and an input pin of the first digital isolator circuit associated with a second channel is coupled to the communication interface of the gate driver circuit.

14. The gate driver system according to any one of claims 10 to 13, comprising
- a second gate driver circuit according to any one of claims 1 to 8,
wherein
- the first gate driver circuit is configured to transmit the gate driver parameter via the first digital isolator circuit to the second gate driver circuit.

15. The gate driver system according to any one of claims 10 to 14, comprising
- a control circuit configured to transmit the gate driver parameter to the first digital isolator.

16. A method of programming one or more gate driver circuits, the method comprising
- transmitting, by a first digital isolator, using an asynchronous serial communication protocol, a gate driver parameter to a first gate driver circuit.

17. The method according to claim 16, comprising
- transmitting, by the first gate driver circuit, using the asynchronous serial communication protocol, the gate driver parameter via the first digital isolator circuit to a second gate driver circuit.

18. The method according to claims 16 or 17, comprising
- transmitting, by a control circuit, the gate driver parameter to the first digital isolator.

## Amended claims

### Amended claims in accordance with Rule 137(2) EPC.

1. A gate driver circuit (11-14, 31-34, 211, 221) configured to drive a gallium nitride GaN transistor, the gate driver circuit (11-14, 31-34, 211, 221) comprising a communication interface configured to receive a gate driver parameter, **characterized in that** the communication interface is an asynchronous serial communication interface.

2. The gate driver circuit (11-14, 31-34, 211, 221) according to claim 1, wherein the communication interface is configured to forward the received gate driver parameter to another gate driver circuit (11-14, 31-34, 211, 221) or to an external control circuit.

3. The gate driver circuit (11-14, 31-34, 211, 221) according to claim 1 or 2, wherein the gate driver parameter is a gate current parameter, and wherein the gate driver circuit (11-14, 31-34, 211, 221) is configured to generate a gate current for driving the GaN transistor (22, 210) based on the gate current parameter.

4. The gate driver circuit (11-14, 31-34, 211, 221) according to any one of the preceding claims, wherein the gate driver parameter is a gate voltage parameter, and wherein the gate driver circuit (11-14, 31-34, 211, 221) is configured to generate a gate voltage for driving the GaN transistor (22, 210) based on the gate voltage parameter.

5. The gate driver circuit (11-14, 31-34, 211, 221) according to any one of the preceding claims, wherein the gate driver circuit (11-14, 31-34, 211, 221) is configured to determine a temperature value of the GaN transistor (22, 210), and wherein the communication interface is configured to transmit said temperature value to an external control circuit or to another gate driver circuit (11-14, 31-34, 211, 221).

6. The gate driver circuit (11-14, 31-34, 211, 221) according to any one of the preceding claims, wherein the gate driver circuit (11-14, 31-34, 211, 221) is configured to determine a current value indicative of a current flowing through the GaN transistor (22, 210), and the communication interface is configured to transmit said current value to an external control circuit or to another gate driver circuit (11-14, 31-34, 211, 221).

7. The gate driver circuit (11-14, 31-34, 211, 221) according to any one of the preceding claims, wherein the gate driver circuit (11-14, 31-34, 211, 221) is configured to determine a fault condition related to the GaN transistor (22, 210) or to the gate driver circuit (11-14, 31-34, 211, 221), and wherein the communication interface is configured to transmit a signal indicative of the fault condition to an external control circuit or to another gate driver circuit (11-14, 31-34, 211, 221).

8. The gate driver circuit (11-14, 31-34, 211, 221) according to any one of the preceding claims, wherein the communication interface is a universal asynchronous receiver-transmitter UART interface.

9. An integrated power switch comprising
- a GaN transistor (22, 210), and
- a gate driver circuit (11-14, 31-34, 211, 221) according to any one of the preceding claims, wherein said gate driver circuit (11-14, 31-34, 211, 221) is coupled to a gate of the GaN transistor (22, 210).

10. A gate driver system comprising
- a first gate driver circuit according to any one of claims 1 to 8, and
- a first digital isolator circuit configured to receive the gate driver parameter and to transmit the gate driver parameter to the first gate driver circuit.

11. The gate driver system according to claim 10, wherein the first digital isolator circuit and the first gate driver circuit are both coupled to the same reference potential.

12. The gate driver system according to claim 10 or 11, wherein the first digital isolator circuit comprises a push-pull output stage.

13. The gate driver system according to any one of claims 10 to 12, wherein the first digital isolator circuit is a two-channel digital isolator circuit, and an output pin of the first digital isolator associated with a first channel is coupled to the communication interface of the gate driver circuit (11-14, 31-34, 211, 221), and an input pin of the first digital isolator circuit associated with a second channel is coupled to the communication interface of the gate driver circuit (11-14, 31-34, 211, 221).

14. The gate driver system according to any one of claims 10 to 13, comprising
- a second gate driver circuit according to any one of claims 1 to 8, wherein
- the first gate driver circuit is configured to transmit the gate driver parameter via the first digital isolator circuit to the second gate driver circuit.

15. The gate driver system according to any one of claims 10 to 14, comprising
- a control circuit (17, 30, 230,) configured to transmit the gate driver parameter to the first digital isolator.

16. A method of programming one or more gate driver circuits (11-14, 31-34, 211, 221), the method being **characterized in that** it comprises
- transmitting, by a first digital isolator, using an asynchronous serial communication protocol, a gate driver parameter to a first gate driver circuit.

17. The method according to claim 16, comprising
- transmitting, by the first gate driver circuit, using the asynchronous serial communication protocol, the gate driver parameter via the first digital isolator circuit to a second gate driver circuit.

18. The method according to claims 16 or 17, comprising
- transmitting, by a control circuit (17, 30, 230,), the gate driver parameter to the first digital isolator.
